# EUROPEAN PATENT APPLICATION

(11) **EP 3 358 925 A1**
(43) Date of publication of application: **08.08.2018**
(21) Application number: 16850904.0
(22) Date of filing: 05.08.2016
(51) Int. Cl.: H05K 9/00, B60R 16/02, H01L 23/29, H05K 3/28, H05K 5/00, H05K 7/14, H05K 7/20

(54) **ELECTRONIC CONTROL DEVICE**

(30) Priority: 29.09.2015 JP 2015190619
(71) Applicant: Hitachi Automotive Systems, Ltd., Hitachinaka-shi, Ibaraki 312-8503 (JP)
(72) Inventor: KANEKO Yujiro, Hitachinaka-shi Ibaraki 312-8503 (JP); KAWAI Yoshio, Hitachinaka-shi Ibaraki 312-8503 (JP)
(74) Representative: MERH-IP Matias Erny Reichl Hoffmann Patentanwälte PartG mbB
(86) International application number: PCT/JP2016/073032
(87) International publication number: WO 2017/056727

(57) **Abstract**

Providing an electronic control device excellent in electromagnetic shielding property with low cost. An electronic control device includes: an electronic component; a control substrate on which the electronic component is mounted; a sealing resin that seals the control substrate; and a metal housing case at least a portion of which is sealed with the sealing resin. The housing case consists of: a heat sink portion a portion of which is exposed from the sealing resin to dissipate heat of the inside of the sealing resin; an electromagnetic shield unit that shields electromagnetic noise by covering the electronic component; and a fixing portion exposed from the sealing resin to achieve fixation to a vehicle body.

## Description

### Technical Field

The present invention relates to an electronic control device such as an engine control unit and an automatic transmission control unit used for an automobile, and particularly to a casing structure of the electronic control device.

### Background Art

With the background of environmental and energy problems, the trend of automobile electronics is accelerating, and the number of electronic control devices installed has been greatly increasing. This leads to limitation of installation space for the electronic control devices, and thus, the electronic control devices are inevitably installed in an engine compartment with severe environmental conditions compared with other locations of an automobile. On the other hand, with a trend of an expanded cabin space to achieve enhanced comfortability of an automobile, the engine compartment has been downsized. This necessitates arrangement of a large number of electronic control devices and wire harnesses in a downsized engine compartment, leading to a difficulty in layout, an increase in weight, and increase in cost. This generates a demand for an electronic control device that is smaller, lighter, and lower in cost. In addition, the wire harness tends to be shortened. This results in, for example, installation of the engine control device at a position closer to the engine, leading to a concern about an influence of high heat and high vibration of the engine on the engine control device. To cope with this, there is a need to enhance heat resistance and vibration resistance of the electronic control device. As a countermeasure, there is a known structure in which a control substrate on which electronic components are mounted is sealed with resin (see PTL 1).

An electric and electronic module described in PTL 1 includes an electronic circuit board on which an electronic circuit is mounted and a metal base for mounting the electronic circuit board, and the electronic circuit board is sealed with a resin.

### Citation List

### Patent Literature

PTL 1: JP 2007-273796 A

### Summary of Invention

### Technical Problem

By sealing the electronic circuit board with a resin, however, there is concern of a decrease in shielding property against electromagnetic noise in comparison with a metal cover. Electromagnetic noise has an influence on an electronic control device and causes, for example, the device to malfunction by the noise generated from on-vehicle components such as an engine, a motor, or the like, or from equipment such as a car radio using external radio-frequency equipment. In addition, the electronic control device might be a noise source in some cases and might cause malfunction of a vehicle-mounted receiving device such as a television receiver, GPS, and Bluetooth (registered trademark). While it is conceivable to add components to enhance shielding property as countermeasures, adding components would inevitably increase the cost.

This makes it a problem to provide an electronic control device excellent in electromagnetic shielding property with low cost.

### Solution to Problem

In order to solve the above-described problem, an electronic control device according to the present invention includes: an electronic component; a control substrate on which the electronic component is mounted; a sealing resin that seals at least a portion of the control substrate; a metal member sealed with the sealing resin, in which the metal member includes a heat sink portion a portion of which is exposed from the sealing resin to dissipate heat of the inside of the sealing resin; a protection portion that covers the electronic component; and a fixing portion a portion of which is exposed from the sealing resin to achieve fixation to a vehicle body.

### Advantageous Effects of Invention

According to the present invention, it is possible to provide an electronic control device excellent in electromagnetic shielding property with low cost.

### Brief Description of Drawings

[FIG. 1] FIG. 1 is a cross-sectional view of an electronic control device.
[FIG. 2] FIG. 2 is a configuration and an assembly procedure of an electronic control device of a first embodiment.
[FIG. 3] FIG. 3 is a configuration of an electronic control device of a second embodiment.
[FIG. 4] FIG. 4 is a configuration of an electronic control device of a third embodiment.
[FIG. 5] FIG. 5 is a configuration of an electronic control device of a fourth embodiment.
[FIG. 6] FIG. 6 is a configuration of an electronic control device of a fifth embodiment.
[FIG. 7] FIG. 7 is a configuration of an electronic control device of a sixth embodiment.

### Description of Embodiments

Hereinafter, a configuration and an assembly procedure of an electronic control device according to specific embodiments of the present invention will be described with reference to the accompanying drawings.

### First Embodiment

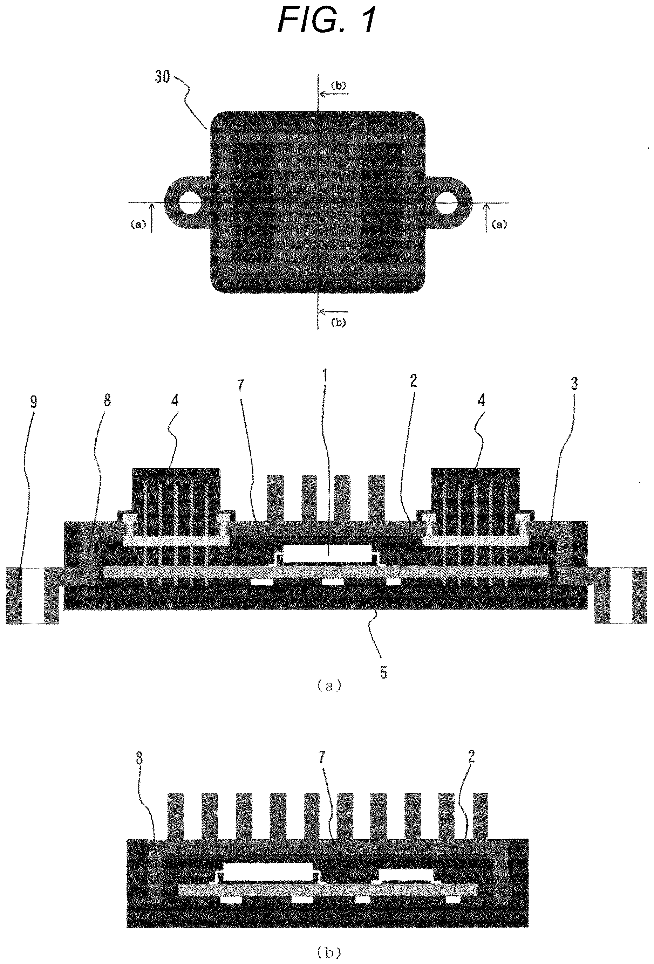

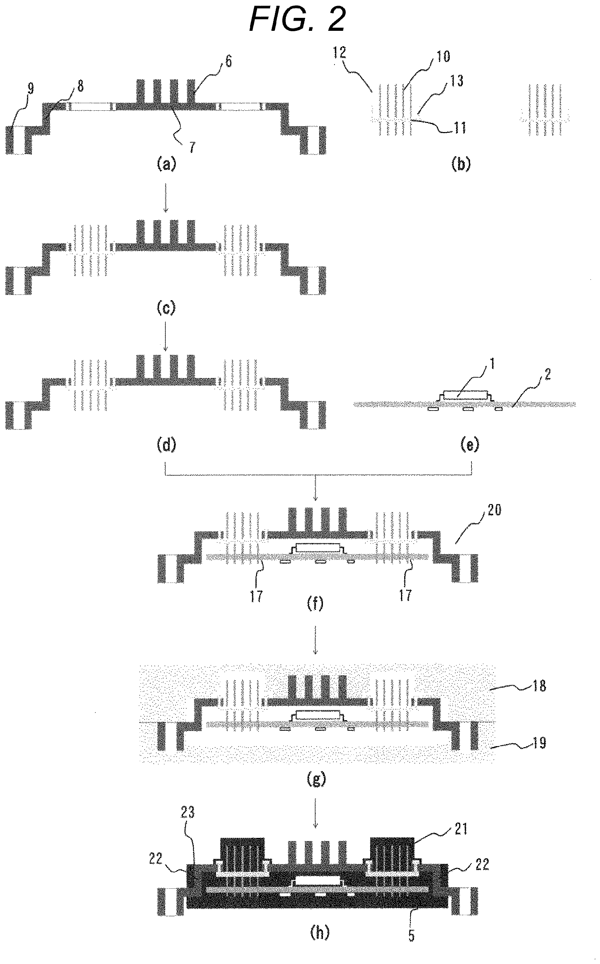

FIG. 1 is a cross-sectional view illustrating a control device according to the first embodiment. FIG. 2 is a configuration and an assembly procedure of the control device illustrated in FIG. 1.

As illustrated in FIGS. 1 and 2, an electronic control device 30 according to the present invention includes a control substrate 2 on which an electronic component 1 such as a microcomputer is mounted, a housing case 3, a connector 4, and a sealing resin 5.

As illustrated in FIG. 2(a), the housing case 3 may be integrally molded together with a heat sink 7 having a heat dissipation fin 6 for dissipating heat generated from electronic components to the outside of the electronic control device 30, an electromagnetic shield unit 8 that shields electromagnetic noise, and a fixture for vehicle mounting 9 for fixing the electronic control device to a vehicle. The material is preferably a metal member having high thermal conductivity, shielding property and rigidity, and it is preferable to use aluminum or an aluminum alloy from the viewpoints of mass productivity, weight reduction, heat dissipation property, and cost. By integrating the heat sink 7, the shield unit 8, and the fixture for vehicle mounting 9 in this manner, it is possible to reduce the number of components, leading to cost reduction and enhancement of productivity.

With the fixture for vehicle mounting 9 integrally molded with the housing case 3, heat dissipated from the electronic component 1 towards the housing case 3 such as the heat sink 7 can be dissipated to the vehicle body via the fixture for vehicle mounting 9.

As illustrated in FIG. 2(b), the connector 4 is formed by fabricating a connector unit assembly 12 constituted with a terminal 10 for connecting a vehicle-side harness with the control substrate 2, and a fixing plate 11 for aligning and holding the terminals 10 at a prescribed pitch. The fixing plate 11 includes pins 13 for increasing insertability into the housing case 3 to be described below and for facilitating positioning. The number of the pins 13 is preferably two or more. The material of the terminal 10 may preferably be copper or a copper alloy from the viewpoint of conductivity, downsizing, and cost. The material of the fixing plate 11 may preferably be a polybutylene terephthalate (PBT) resin, a polyamide (PA) 66 resin, and a polyphenylene sulfide (PPS) resin from the viewpoint of light weight and excellent heat resistance.

Subsequently, as illustrated in FIG. 2(c), the housing case 3 and the connector unit assembly 12 are assembled to each other. At that time, the pins 13 of the connector unit assembly 12 are inserted into mutually opposing penetration holes on the housing case 3, and the fixing plate 11 is brought into contact with the housing case 3, thereby positioning the connector unit assembly 12 and the housing case 3.

When the position of the connector unit assembly 12 with respect to the housing case 3 is determined, tips of the pins 13 protruding from the housing case 3 are fixed by thermal caulking as illustrated in FIG. 2(d).

After the connector unit assembly 12 is fixed, the control substrate 2 on which the electronic component 1 such as a microcomputer is mounted is assembled to the die casting case 3 as illustrated in FIGS. 2(e) and 2(f). At that time, an electronic component susceptible to external electromagnetic noise and an electronic component likely to generate electromagnetic noise, such as a microcomputer and a quartz oscillator, are mounted on a surface of the control substrate 2 facing the housing case 3. This configuration enables the electronic component 1 to be surrounded by wiring layers of the housing case 3 and the control substrate 2, leading to enhancement of the electromagnetic shielding property. In order to further enhance the electromagnetic shielding property, it is preferable to provide a solid pattern in one layer of the wiring layers of the control substrate or in the periphery where the electronic component 1 is mounted. This makes it possible to also enhance the shielding property against electromagnetic noise from the surface not facing the housing case 3.

A resin wiring board based on glass epoxy resin or the like is used as the control substrate 2. In connecting the electronic component 1 to the control substrate 2, a lead-free solder such as Sn-Cu solder, Sn-Ag-Cu solder, and Sn-Ag-Cu-Bi solder is applied. By setting the control substrate 2 on a substrate receiving unit (not illustrated) of the housing case 3, the position in a height direction is determined, and subsequently the control substrate 2 is fixed to the housing case 3 using screws (not illustrated). The number of fixation points by screws may preferably be three or more. In connecting the terminal 10 of the connector unit assembly 12 with the control substrate 2, a lead-free solder such as Sn-Cu solder, Sn-Ag-Cu solder, and Sn-Ag-Cu-Bi solder is applied to a through hole portion 17 of the control substrate 2, into which the terminal 10 is inserted, so as to achieve connection. Note that the type of the connector 4 may be a surface mounting type or a press fit type.

What is important here is a method of fixing the connector unit assembly 12. Specifically, in a case where the connector unit assembly 12 is fixed to the control substrate 2 instead of the housing case 3, the positioning pin 13 is to be inserted into the control substrate 2. This would generate a need to provide a penetration hole for the positioning pin 13 on the control substrate 2, and increase the substrate area correspondingly. In addition, in a case where the terminal 10 of the connector unit assembly 12 and the through hole portion 17 of the control substrate 2 are joined with each other, the connector unit assembly 12 and the control substrate 2 individually expand and contract due to a thermal history by joining. In this process, however, there is a difference in the amount of expansion and contraction between the connector unit assembly 12 and the control substrate 2, leading to generation of warping in the connector unit assembly 12 and the control substrate 2 after joining. Furthermore, due to greater rigidity of the housing base 3 and the flat shape of a substrate receiving surface, fixing the connector unit assembly 12 and the control substrate 2 joined with each other to the housing base 3 would bring the warping of the connector unit assembly 12 and the control substrate 2 with low rigidity back to a former state. This would generate a peeling stress in a joint portion between the terminal 10 and the through hole portion 17.

To cope with this problem, as described in the embodiment, the method of fixing the connector unit assembly 12 may preferably include first fixing the connector unit assembly 12 to the housing case 3, and thereafter joining the terminal 10 of the connector unit assembly 12 to the through hole portion 17 of the control substrate 2. By additionally implementing this method, it is possible to further suppress the warping of the connector unit assembly 12 and the control substrate 2, and also to suppress generation of stress at the joint portion between the terminal 10 and the through hole portion 17.

As illustrated in FIG. 2(g), a sub-assembly 20 fabricated in this manner is set in a mold for resin sealing. In the present embodiment, the sub-assembly is set on an upper die 18 that is a movable die, then the upper die is moved and set onto a lower die 19 as a fixed die. The fin portion 6 of the housing cover 3 to be desirably exposed from the resin 5 after resin sealing and the fixture for vehicle mounting 9 have a structure to be held by a mold in order to prevent entry of resin during resin molding.

For the purpose of ensuring the fluidity of the sealing resin 5 and enabling the resin to fill over narrower sites inside of the mold, it is preferable to preheat the mold, the sub-assembly, and the resin. The sealing resin 5 may be a thermosetting epoxy resin, an unsaturated polyester resin, or a thermoplastic resin. Examples of sealing methods include transfer molding, compression molding, injection molding, and hot melt. Physical property values of the sealing resin 5 are desirably such that the linear expansion coefficient is 10 to 30 × 10⁻⁶/°C, the thermal conductivity is 0.5 to 3 W/mK.

After completion of resin filling into the mold, the sealing resin 5 is cured in the mold. After curing, the mold is opened and the resin molded product is taken out to complete fabrication of the electronic control device 30 illustrated in FIG. 2 (h) .

Note that a rising portion 22 on the outer periphery of the housing case excluding the fixture for vehicle mounting 9 is preferably covered with the sealing resin 5. This configuration increases the contact area between the housing case 3 and the sealing resin 5, making it possible to enhance waterproof/anti-saline reliability. Since this configuration further enables reduction of expansion and shrinkage of the housing case 3, it is possible to enhance waterproof and anti-saline reliability and solder connection reliability.

Moreover, the surface of the housing case 3 and the surface of the sealing resin 5 may preferably be on a same surface at a contact end 23 of the housing case 3 and the sealing resin 5. This makes it possible to suppress accumulation of water, salt water, and foreign matter at the contact end 23.

In addition, it is further preferable to cover the thermal caulking portion of the connector terminal fixing plate 11 with the sealing resin 5.

This makes it possible to suppress deterioration of the thermal caulking portion and suppress entry of water and salt water from the thermal caulking portion.

Finally, a housing 21 of the connector 4 is also integrally molded with the sealing resin 5. This can omit necessity to provide the connector housing as a separate component, leading to reduction of the number of components, and probably leading to a cost advantage and productivity enhancement.

### Second Embodiment

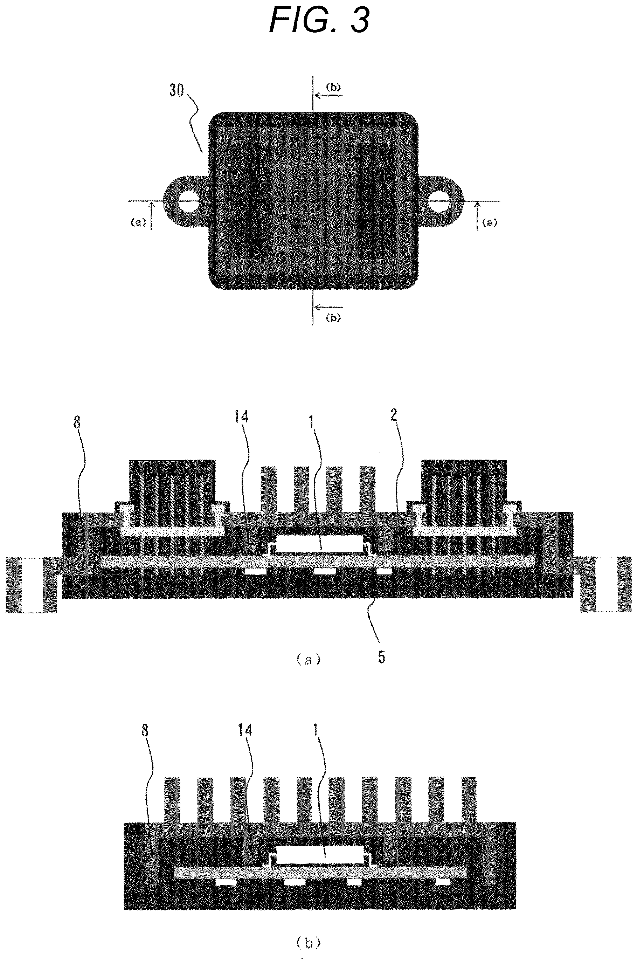

The configuration of a second embodiment will be described in comparison with the first embodiment. While the first embodiment is a case where the electromagnetic shield unit 8 covers an entire periphery of the side surface of the control substrate 2, the second embodiment has a structure in which an outer periphery of the electronic component 1 is surrounded by a frame body 14 extending from the housing case 3 toward the control substrate 2 in addition to covering the entire periphery of the side surface of the control substrate 2, as illustrated in FIG. 3. By doubly covering the outer periphery of the control substrate 2 and the outer periphery of the electronic component 1, it is possible to further enhance electromagnetic shielding property.

### Third Embodiment

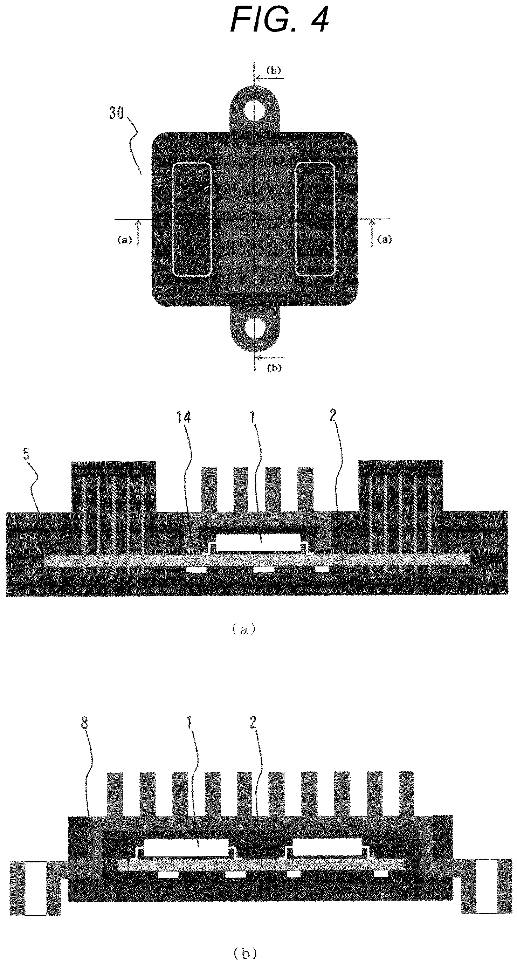

The configuration of a third embodiment will be described in comparison with the first embodiment. While the first embodiment has a structure in which the electromagnetic shield unit 8 covers the entire periphery of the side surface of the control substrate 2, the third embodiment is configured such that the electromagnetic shield unit 8 covers the control substrate 2 on two side surfaces out of four side surfaces as illustrated in FIG. 4(b) similarly to the first embodiment, while the electronic component 1 is covered by a region smaller than a width of the control substrate 2 on the other two sides as illustrated in FIG. 4(a). The present embodiment is effective when it is judged that there is no need to cover the entire periphery of the side surface of the control substrate 2 with the housing case 3 after examination of desired electromagnetic shielding property. With this configuration, it is possible to reduce material cost by reducing the capacity of the housing case 3 while maintaining the electromagnetic shielding performance.

### Fourth Embodiment

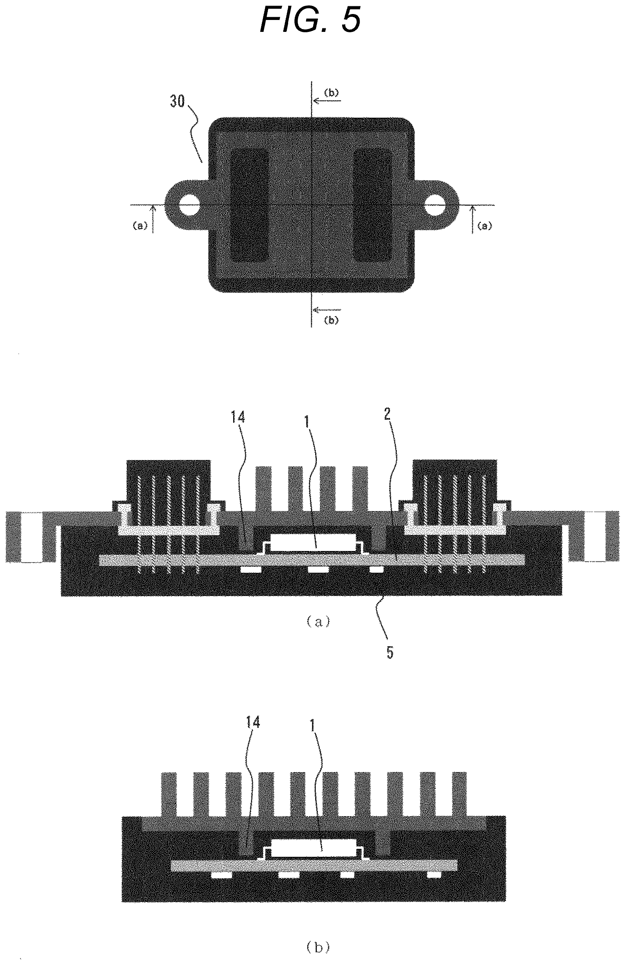

The configuration of a fourth embodiment will be described in comparison with the first embodiment. While the first embodiment is a case where the electromagnetic shield unit 8 covers the entire periphery of the side surface of the control substrate 2, the fourth embodiment has a structure in which the outer periphery of the electronic component 1 is surrounded by the frame body 14 extending from the housing case 3 toward the control substrate 2 within a region smaller than the width of the control substrate 2 as illustrated in FIG. 5. The present embodiment is effective when it is judged that there is no need to cover the entire periphery of the side surface of the control substrate 2 with the housing case 3 after examination of desired electromagnetic shielding property. With this configuration, it is possible to reduce material cost by reducing the capacity of the housing case 3 while maintaining the electromagnetic shielding performance.

### Fifth Embodiment

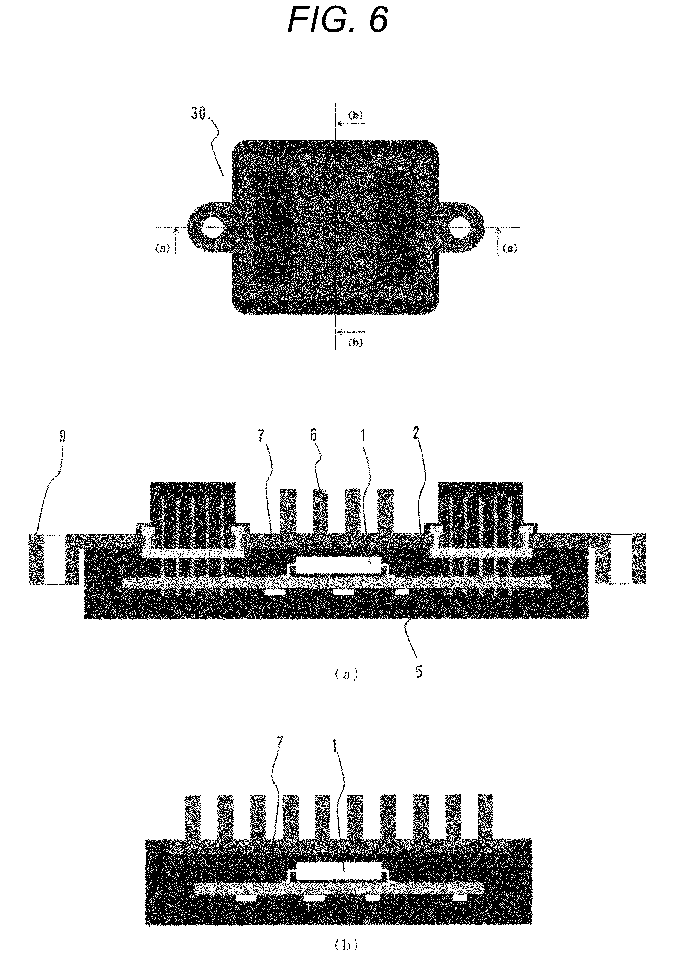

The configuration of a fifth embodiment will be described in comparison with the first embodiment. While the first embodiment is a case where the housing case 3 is integrally molded together with the heat sink 7 having the heat dissipation fin 6, the electromagnetic shield unit 8 that shields electromagnetic noise, and the fixture for vehicle mounting 9 for fixing the electronic control device to a vehicle, the fifth embodiment has a structure in which the heat sink 7 and the fixture for vehicle mounting 9 are integrally molded as illustrated in FIG. 6. The present embodiment is effective when it is judged that the desired electromagnetic shielding performance can be satisfied with a configuration in which the electronic component 1 is surrounded from vertical directions by the housing case 3 and the wiring layer of the control substrate 2 without covering entire periphery of the side surface of the control substrate 2 by the housing case 3. With this configuration, it is possible to reduce material cost by reducing the capacity of the housing case 3 while maintaining the electromagnetic shielding performance.

### Sixth Embodiment

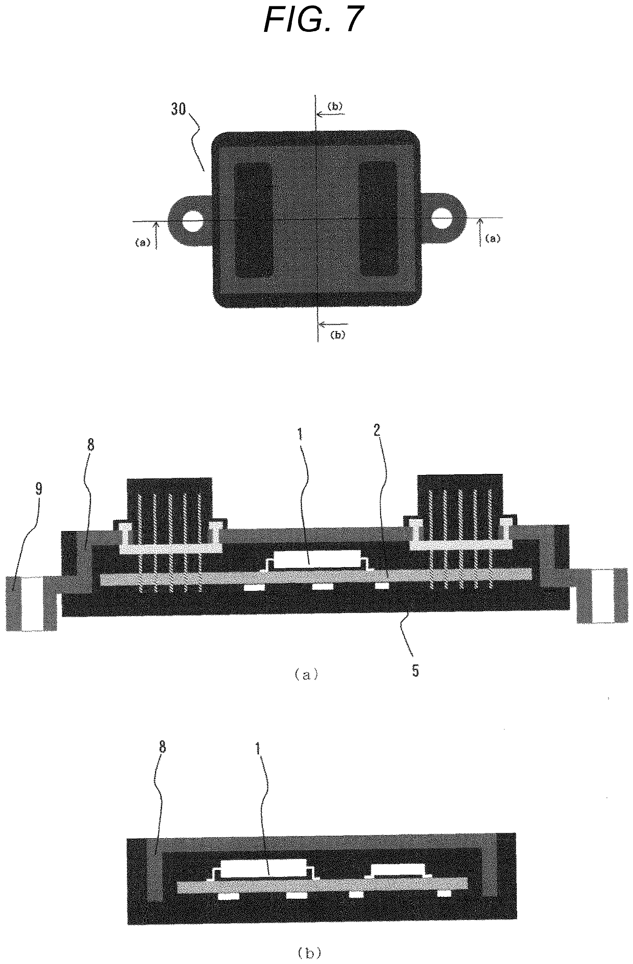

The configuration of a sixth embodiment will be described in comparison with the first embodiment. While the first embodiment is a case where the housing case 3 is integrally molded together with the heat sink 7 having the heat dissipation fin 6, the electromagnetic shield unit 8 that shields electromagnetic noise, and the fixture for vehicle mounting 9 for fixing the electronic control device to a vehicle, the sixth embodiment has a structure in which the electromagnetic shield unit 8 and the fixture for vehicle mounting 9 are integrally molded as illustrated in FIG. 7. With the fixture for vehicle mounting 9 integrally molded with the housing case 3, heat dissipated from the electronic component 1 towards the housing case 3 such as the electromagnetic shield unit 8 can be dissipated to the vehicle body via the fixture for vehicle mounting 9. The present embodiment is effective when it is judged that the heat dissipation performance can be satisfied with no heat dissipation fin 6, whereby the material cost can be reduced by reducing the capacity of the housing case 3.

As above, embodiments of the control device according to the present invention have been described. The present invention is not limited to the above-described embodiments but may include various design modifications without departing from the spirit according to the present invention described in claims.

### Reference Signs List

1 electronic component
2 control substrate
3 housing case
4 connector
5 sealing resin
5a sealing resin to cover heat dissipation fin
5b sealing resin to cover rising portion of outer periphery
of housing case
6 heat dissipation fin
7 heat sink
8 electromagnetic shield unit
9 fixture for vehicle mounting
10 terminal
11 fixing plate
12 connector unit assembly
13 pin
14 frame body
17 through hole portion
18 upper mold
19 lower mold
20 sub-assembly
21 connector housing
22 rising portion of outer periphery of housing case
23 contact end of housing case and sealing resin
24 penetration hole
25 mold
30 electronic control device

## Claims

1. An electronic control device comprising:
an electronic component;
a control substrate on which the electronic component is mounted;
a sealing resin that seals at least a portion of the control substrate;
a metal member sealed with the sealing resin,
wherein the metal member includes:
a heat sink portion a portion of which is exposed from the sealing resin to dissipate heat of the inside of the sealing resin;
a shield unit that shields the electronic component; and
a fixing portion a portion of which is exposed from the sealing resin to achieve fixation to a vehicle body.

2. The electronic control device according to claim 1,
wherein the shield unit is an electromagnetic shield unit that shields electromagnetic noise emitted between the electronic component and an external space.

3. The electronic control device according to claim 2,
wherein the metal member forms the electromagnetic shield unit on an outer periphery of the heat sink portion, and
forms the fixing portion on an outer periphery of the electromagnetic shield unit.

4. The electronic control device according to any one of claims 2 and 3,
wherein the heat sink portion has a heat dissipation fin, and the heat dissipation fin is exposed from the sealing resin.

5. The electronic control device according to any one of claims 2 to 4,
wherein the metal member has a rising portion on the outer periphery of the heat sink portion and forms the electromagnetic shield unit by forming an outline in a recessed shape.

6. The electronic control device according to claim 5, wherein the control substrate is housed in the portion with a recessed shape.

7. The electronic control device according to any one of claims 1 to 6,
wherein the electronic component is mounted on a surface of the control substrate facing the metal member.

8. The electronic control device according to claim 7,
wherein at least a microcomputer and a quartz oscillator among the electronic components are mounted on the surface of the control substrate facing the metal member.

9. The electronic control device according to any one of claims 7 and 8,
wherein a frame body protruding from the housing case is formed on an outer periphery of the electronic component mounted on a surface of the control substrate facing the housing case.

10. The electronic control device according to any one of claims 1 to 9, wherein a material of the metal member is one of aluminum and an aluminum alloy.

11. An electronic control device comprising:
an electronic component;
a control substrate on which the electronic component is mounted;
a sealing resin that seals at least a portion of the control substrate; and
a metal member sealed with the sealing resin,
wherein the metal member includes:
a heat sink portion a portion of which is exposed from the sealing resin to dissipate heat of the inside of the sealing resin; and
a fixing portion a portion of which is exposed from the sealing resin to achieve fixation to a vehicle body,
the heat sink portion and the fixing portion are integrally molded, and
the electronic component is mounted on a surface of the control substrate facing the metal member.

12. An electronic control device comprising:
an electronic component;
a control substrate on which the electronic component is mounted;
a sealing resin that seals at least a portion of the control substrate; and
a metal member sealed with the sealing resin,
wherein the metal member includes:
an electromagnetic shield unit that shields electromagnetic noise emitted between the electronic component and an external space; and
a fixing portion a portion of which is exposed from the sealing resin to achieve fixation to a vehicle body, and
the electromagnetic shield unit and the fixing portion are integrally molded, and
the electronic component is mounted on a surface of the control substrate facing the metal member.

13. The electronic control device according to any one of claims 7, 11, and 12,
wherein the control substrate includes a solid pattern in at least one layer or in a region where the electronic component is provided.
